# EUROPEAN PATENT APPLICATION

(11) **EP 4 761 046 A1**
(43) Date of publication of application: **17.06.2026**
(21) Application number: 25816096.9
(22) Date of filing: 26.05.2025
(51) Int. Cl.: H02J 7/00, G01R 31/382, G01R 31/389, H01M 10/44

(54) **APPARATUS AND METHOD FOR GENERATING CHARGING PROTOCOL**

(30) Priority: 30.05.2024 KR 20240070934
(71) Applicant: LG Energy Solution, Ltd., Seoul 07335 (KR)
(72) Inventor: WHANG, Tae-Kyung, Daejeon 34122 (KR); PARK, Tae-Soon, Daejeon 34122 (KR); LEE, Ji-Eun, Daejeon 34122 (KR)
(74) Representative: Goddar, Heinz J.
(86) International application number: PCT/KR2025/007103
(87) International publication number: WO 2025/249855

(57) **Abstract**

A charging protocol generating apparatus according to an embodiment of the present disclosure includes a profile obtaining unit configured to obtain a charging profile of a battery charged by repeating a charging period and a rest period at a preset charging C-RATE; and a control unit configured to generate a resistance profile representing a corresponding relationship between a resistance of the plurality of rest periods and SOC (State of Charge), determine a maximum allowable SOC corresponding to the charging C-RATE based on a resistance pattern of a target SOC section of the generated resistance profile, and generate a charging protocol including a corresponding relationship between the charging C-RATE and the maximum allowable SOC.

## Description

### TECHNICAL FIELD

This application is based on and claims priority from Korean Patent Application No. 10-2024-0070934, filed on May 30, 2024, with the Korean Intellectual Property Office, the disclosure of which is incorporated herein in its entirety by reference.

The present disclosure relates to a charging protocol generating apparatus and method and more specifically, to an apparatus and method for generating a rapid charging protocol.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

As electric vehicles, electric motorcycles, and electric bicycles, etc., are commercialized, the demand for high-capacity and high-performance batteries is increasing. However, as the capacity of the battery increases, the time required to charge the battery also increases, which is a disadvantage. To solve this problem, a technology for rapidly charging batteries is being developed, but there is a concern that rapid charging may accelerate battery deterioration.

In particular, during the rapid charging process of the battery, a phenomenon of lithium metal being deposited on the surface of the negative electrode (lithium plating, Li-plating) may occur. If lithium is deposited on the surface of the negative electrode, it causes side reactions with the electrolyte and changes in the kinetic balance of the battery, which may cause battery deterioration. In addition, since an internal short circuit may occur in the battery as lithium metal is deposited on the surface of the negative electrode, there is a risk of ignition and explosion due to the internal short circuit. Therefore, it is necessary to develop a charging protocol that may prevent lithium metal from being deposited on the surface of the negative electrode and rapidly charge the battery.

### DISCLOSURE

### Technical Problem

The present disclosure is designed to solve the problems of the related art, and therefore the present disclosure is directed to generating a charging protocol capable of efficiently and rapidly charging a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A charging protocol generating apparatus according to one aspect of the present disclosure may comprise a profile obtaining unit configured to obtain a charging profile of a battery charged by repeating a charging period and a rest period at a preset charging C-RATE; and a control unit configured to generate a resistance profile representing a corresponding relationship between a resistance of the plurality of rest periods and SOC (State of Charge), determine a maximum allowable SOC corresponding to the charging C-RATE based on a resistance pattern of a target SOC section of the generated resistance profile, and generate a charging protocol including a corresponding relationship between the charging C-RATE and the maximum allowable SOC.

The control unit may be configured to calculate the resistance of each of the plurality of rest periods based on a voltage drop of each of the plurality of rest periods and a current value corresponding to the charging C-RATE.

The control unit may be configured to calculate the voltage drop by calculating a difference between a voltage at a target point and a voltage at an end point in each of the plurality of rest periods.

The control unit may be configured to determine the target point as a point with a largest voltage among points where an instantaneous rate of change of voltage is greater than or equal to a preset reference change rate in each of the plurality of rest periods.

The control unit may be configured to set a voltage change rate of a start point and the end point as the reference change rate corresponding to the rest period in each of the plurality of rest periods.

When a resistance corresponding to an upper limit SOC of the target SOC section is largest among the plurality of resistances corresponding to the target SOC section of the resistance profile, the control unit may be configured to set the maximum allowable SOC as the upper limit SOC.

When a resistance greater than a resistance corresponding to an upper limit SOC of the target SOC section exists among the plurality of resistances corresponding to the target SOC section of the resistance profile and at least one maximum point exists in the target SOC section, the control unit may be configured to set the maximum allowable SOC based on the at least one maximum point.

When a resistance greater than a resistance corresponding to an upper limit SOC of the target SOC section exists among the plurality of resistances corresponding to the target SOC section of the resistance profile, no maximum point exists in the target SOC section, and at least one inflection point exists in the target SOC section, the control unit may be configured to set the maximum allowable SOC based on the at least one inflection point.

A battery pack according to another aspect of the present disclosure may include the charging protocol generating device according to one aspect of the present disclosure.

A server according to still another aspect of the present disclosure may include the charging protocol generating device according to one aspect of the present disclosure.

A battery charging control device according to still another aspect of the present disclosure may include a memory configured to store the charging protocol generated by the charging protocol generating apparatus according to one aspect of the present disclosure; and a processor configured to control charging of a charging target battery based on the charging protocol.

A charging protocol generating method according to still another aspect of the present disclosure may comprise a charging profile obtaining step of obtaining a charging profile of a battery charged by repeating a charging period and a rest period at a preset charging C-RATE; a resistance profile generating step of generating a resistance profile representing a corresponding relationship between a resistance of the plurality of rest periods and SOC (State of Charge); a maximum allowable SOC determining step of determining a maximum allowable SOC corresponding to the charging C-RATE based on a resistance pattern of a target SOC section of the generated resistance profile; and a charging protocol generating step of generating a charging protocol including a corresponding relationship between the charging C-RATE and the maximum allowable SOC.

### Advantageous Effects

According to one aspect of the present disclosure, the charging protocol generating apparatus may generate a charging protocol that prevents lithium plating from occurring during the charging process. That is, the charging protocol generating apparatus has the advantage of being able to generate a charging protocol that may increase the expected life of the battery by preventing unnecessary degradation of the battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a drawing schematically illustrating a charging protocol generating apparatus according to an embodiment of the present disclosure.
FIG. 2 is a drawing schematically illustrating a charging profile according to an embodiment of the present disclosure.
FIG. 3 is an enlarged view showing a portion of the charging profile of FIG. 2.
FIGS. 4 to 6 are schematic drawings illustrating a resistance profile according to an embodiment of the present disclosure.
FIG. 7 is a schematic drawing showing a charging protocol according to an embodiment of the present disclosure.
FIG. 8 is a diagram schematically showing a battery pack according to still another embodiment of the present disclosure.
FIG. 9 is a diagram schematically showing a server according to still another embodiment of the present disclosure.
FIG. 10 is a diagram schematically showing a charging control device according to still another embodiment of the present disclosure.
FIG. 11 is a diagram schematically showing a battery pack according to still another embodiment of the present disclosure.
FIG. 12 is a diagram schematically showing a charging device according to still another embodiment of the present disclosure.
FIG. 13 is a diagram schematically showing a vehicle according to still another embodiment of the present disclosure.
FIG. 14 is a diagram schematically showing a charging protocol generating method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

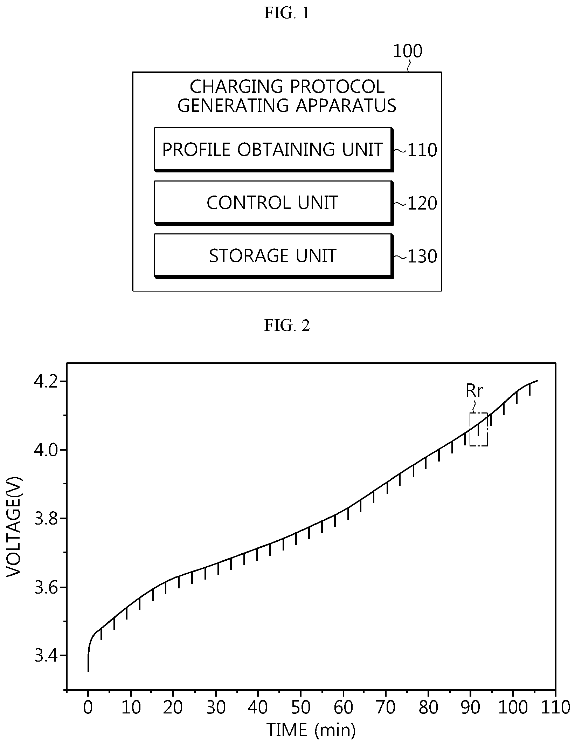

FIG. 1 is a diagram schematically illustrating a charging protocol generating apparatus 100 according to an embodiment of the present disclosure.

Referring to FIG. 1, the charging protocol generating apparatus 100 may include a profile obtaining unit 110 and a control unit 120.

Here, the battery refers to an independent cell that has a negative terminal and a positive terminal and is physically separable. As an example, a lithium-ion battery or a lithium polymer battery may be considered as a battery. In addition, the type of batteries may be a cylindrical type, a prismatic type or a pouch type. Additionally, the battery may mean a battery bank, a battery module or a battery pack in which a plurality of cells are connected in series and/or parallel. Below, for convenience of explanation, the battery is explained as meaning one independent cell.

The profile obtaining unit 110 may be configured to obtain a charging profile of a battery charged by repeating a charging period and a rest period at a preset charging C-RATE (current rate).

Specifically, the battery may be charged until the state of charge (SOC) is charged from a preset charging start SOC or 0% to a preset charging end SOC or 100%. Preferably, the charging C-RATE may be kept constant during the charging process of the battery. Here, the charging C-RATE may be a C-RATE selected to set or change the maximum allowable SOC.

Additionally, the battery may be charged by repeating a charging period and a rest period. For example, the battery may be charged for a first time, and charging may be stopped for a second time. Preferably, the rest period may be repeated at preset intervals.

FIG. 2 is a drawing schematically illustrating a charging profile according to an embodiment of the present disclosure. Specifically, the charging profile may be set to represent the corresponding relationship between time (X-axis) and voltage (Y-axis). However, depending on the embodiment, the charging profile may also be set to represent the corresponding relationship between the SOC and voltage of the battery or the capacity and voltage.

In the embodiment of FIG. 2, the battery is charged for about 105 minutes by repeating the charging period and rest period, and the rest period is repeated about every 3 minutes. Since the battery is in a no-load state during the rest period (Rr), the voltage of the battery may drop during the rest period.

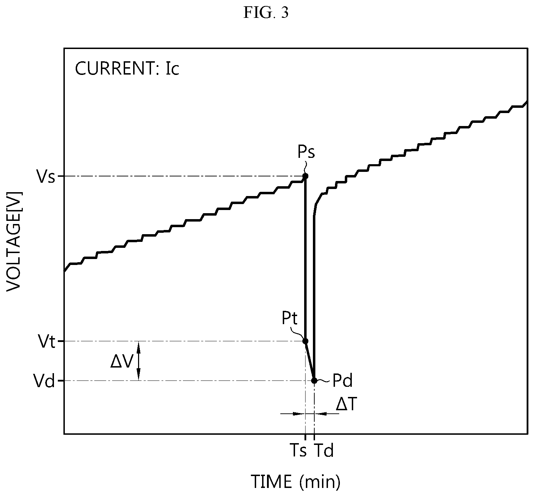

FIG. 3 is an enlarged view showing a portion of the charging profile of FIG. 2. Specifically, a rest period may proceed for a period of ΔT (Td - Ts). The voltage at the start point Ps of the rest period is Vs, and the voltage at the end point Pd of the rest period is Vd. That is, during the rest period, the voltage of the battery may drop by "Vs - Vd".

For example, the profile obtaining unit 110 may directly receive the charging profile of the battery from the outside. That is, the profile obtaining unit 110 may obtain the charging profile by being connected to the outside via wire and/or wirelessly and receiving the charging profile.

As another example, the profile obtaining unit 110 may receive voltage information according to the charging time of the battery from the outside. Then, the profile obtaining unit 110 may generate a charging profile based on the received voltage information. That is, the profile obtaining unit 110 may obtain a charging profile by directly generating the charging profile based on the voltage information of the battery.

The profile obtaining unit 110 may be connected to communicate with the control unit 120. For example, the profile obtaining unit 110 may be connected to the control unit 120 by wire and/or wirelessly. The profile obtaining unit may transmit the obtained charging profile to the control unit 120.

The control unit 120 may be configured to generate a resistance profile representing a corresponding relationship between resistance of a plurality of rest periods and a state of charge (SOC).

Specifically, the control unit 120 may determine the resistance and SOC for each rest period. Then, the control unit 120 may map the corresponding resistance and SOC to generate a resistance profile representing the corresponding relationship between the resistance and SOC.

First, the control unit 120 may be configured to calculate the resistance of each of the plurality of rest periods based on the voltage drop of each of the plurality of rest periods and the current value corresponding to the charging C-RATE. That is, since the battery is in a no-load state during the rest period, the voltage of the battery naturally decreases. The control unit 120 may calculate the resistance corresponding to the rest period from the voltage drop of the rest period and the current value according to the charging C-RATE using Ohm's law. For example, in the embodiment of FIG. 3, the voltage drop of the rest period is "Vs - Vd" and the current is Ic. Therefore, the control unit 120 may calculate the resistance of the rest period by calculating the formula "(Vs - Vd) ÷ Ic".

And, the control unit 120 may estimate the SOC corresponding to the rest period.

For example, the control unit 120 may estimate the SOC corresponding to the voltage of the start point of the rest period by using the table representing the corresponding relationship between SOC and voltage. In the embodiment of FIG. 3, the control unit 120 may estimate the SOC corresponding to the rest period by comparing the voltage (Vs) of the start point Ps of the rest period with the preset table.

As another example, the control unit 120 may estimate the SOC of the rest period based on the capacity of the battery charged until the rest period. In this case, the control unit 120 may estimate the SOC by using a current integration method (ampere counting, coulomb counting) that adds up the charging current until the rest period. In the embodiment of FIG. 3, the control unit 120 may estimate the SOC corresponding to the rest period based on the capacity of the battery charged until the start point Ps of the rest period. Preferably, the control unit 120 may calculate the capacity of the battery charged until the rest period based on the total charging time and current. Here, the control unit 120 may calculate the total charging time by adding up only the time of the charging period, excluding the time of the previous rest period.

The control unit 120 may estimate resistance and SOC for each of the plurality of rest periods, and generate a resistance profile representing a corresponding relationship between the estimated resistance and SOC. For example, the resistance profile may be expressed as an X-Y graph in which the X-axis is set to SOC and the Y-axis is set to resistance.

The control unit 120 may be configured to determine the maximum allowable SOC corresponding to the charging C-RATE based on the resistance pattern of the target SOC section of the generated resistance profile.

Here, the maximum allowable SOC means the maximum SOC at which lithium plating phenomenon is estimated not to occur when the battery is charged at the charging C-RATE. This maximum allowable SOC for each charging C-RATE may be determined based on the resistance pattern of the target SOC section included in the resistance profile. Here, the target SOC section means a section with an SOC of 50% or more based on the BOL (Beginning of life) battery. In other words, as the battery deteriorates or the charging C-RATE increases, the ratio included in the target SOC section in the resistance profile may decrease.

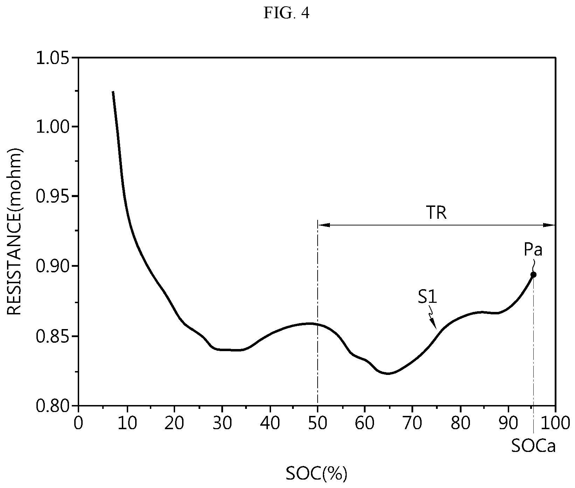

Hereinafter, an embodiment in which the control unit 120 sets a maximum allowable SOC will be described with reference to FIGS. 4 to 6. FIGS. 4 to 6 are schematic drawings illustrating a resistance profile according to an embodiment of the present disclosure.

For example, the control unit 120 may be configured to set the maximum allowable SOC as the upper limit SOC when the resistance corresponding to the upper limit SOC of the target SOC section is largest among the plurality of resistances corresponding to the target SOC section of the resistance profile.

Specifically, when the resistance corresponding to the upper limit SOC of the target SOC section is largest, the maximum allowable SOC for the charging C-RATE may be set to the upper limit SOC even if a maximum point and/or an inflection point exist in the target SOC section.

In the embodiment of FIG. 4, the first resistance profile S1 is a profile for a battery charged at C1 C-RATE. In the first resistance profile S1, Pa is an upper limit of the target SOC section TR. Among the plurality of resistances belonging to the target SOC section TR, the resistance corresponding to Pa is largest. Therefore, the maximum allowable SOC corresponding to C1 C-RATE may be set to SOCa corresponding to Pa.

As another example, the control unit 120 may be configured to set the maximum allowable SOC based on at least one maximum point when a resistance greater than the resistance corresponding to the upper limit SOC of the target SOC section exists among the plurality of resistances corresponding to the target SOC section of the resistance profile and at least one maximum point exists in the target SOC section.

Specifically, if the resistance corresponding to the upper limit SOC of the target SOC section is not greatest and a maximum point exists in the target SOC section, the maximum allowable SOC for the charging C-RATE may be set to the SOC of the maximum point even if an inflection point exists in the target SOC section.

Preferably, if the target SOC section includes a plurality of maximum points, SOC of one of the plurality of maximum points may be set as the maximum allowable SOC. More preferably, the largest SOC among the SOCs corresponding to the plurality of maximum points may be set as the maximum allowable SOC.

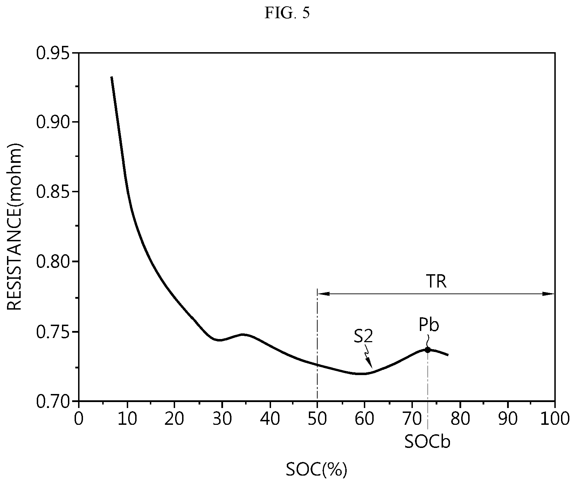

In the embodiment of FIG. 5, the second resistance profile S2 is a profile for a battery charged at C2 C-RATE. In the second resistance profile S2, Pb is the maximum point of the target SOC section TR. Among the plurality of resistances belonging to the target SOC section TR, the resistance corresponding to Pb is largest. That is, among the plurality of resistances belonging to the target SOC section TR, the resistance corresponding to the upper limit of the target SOC section TR is not largest. Therefore, the maximum allowable SOC corresponding to C2 C-RATE may be set to SOCb corresponding to Pb.

As still another example, the control unit 120 may be configured to set the maximum allowable SOC based on the at least one inflection point, if a resistance greater than the resistance corresponding to the upper limit SOC of the target SOC section exists among the plurality of resistances corresponding to the target SOC section of the resistance profile, no maximum point exists in the target SOC section, and at least one inflection point exists in the target SOC section.

Specifically, even if an inflection point exists in the target SOC section, only if the resistance corresponding to the upper limit SOC is not largest among the plurality of resistances included in the target SOC section and the maximum point does not exist in the target SOC section, the SOC corresponding to the inflection point may be set as the upper limit SOC, which is the maximum allowable SOC for the charging C-RATE. This is because the maximum allowable SOC must be conservatively and strictly set to represent a SOC at which lithium plating does not occur even if the battery is charged at the charging C-RATE.

Preferably, when the target SOC section includes a plurality of inflection points, SOC of one of the plurality of inflection points may be set as the maximum allowable SOC. More preferably, the largest SOC among the SOCs corresponding to the plurality of inflection points may be set as the maximum allowable SOC.

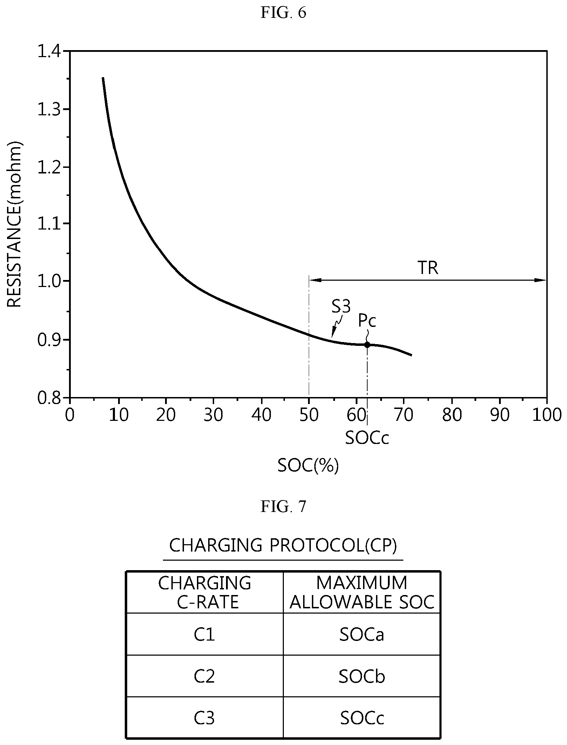

In the embodiment of FIG. 6, the third resistance profile S3 is a profile for a battery charged at C3 C-RATE. In the third resistance profile S3, Pc is an inflection point of the target SOC section TR. Among the plurality of resistances belonging to the target SOC section TR, the resistance corresponding to the upper limit SOC is not largest, and no maximum point exists in the target SOC section TR. Therefore, the maximum allowable SOC corresponding to C3 C-RATE may be set to SOCc corresponding to Pc.

The control unit 120 may be configured to generate a charging protocol including a corresponding relationship between the charging C-RATE and the maximum allowable SOC.

The control unit 120 may set a maximum allowable SOC corresponding to the charging C-RATE and generate a charging protocol representing a corresponding relationship between them. That is, the charging protocol may include information on a maximum allowable SOC at which lithium plating does not occur for each charging C-RATE.

FIG. 7 is a schematic drawing showing a charging protocol according to an embodiment of the present disclosure.

Specifically, the charging protocol CP of FIG. 7 is a charging protocol that represents a corresponding relationship between the charging C-RATE and the maximum allowable SOC set in the embodiments of FIGS. 4 to 6. In the embodiment of FIG. 7, the maximum allowable SOC for C1 C-RATE is set to SOCa, the maximum allowable SOC for C2 C-RATE is set to SOCb, and the maximum allowable SOC for C3 C-RATE is set to SOCc.

For example, when the battery is charged at the C1 C-RATE, lithium plating may occur in the battery at a SOC exceeding the SOCa. Therefore, the battery may be first charged at the C1 C-RATE until the SOC of the battery reaches SOCa, and then the battery may be charged at a C-RATE whose maximum allowable SOC is higher than SOCa. Since decreasing the charging C-RATE increases the charging time of the battery, preferably, when the SOC of the battery reaches a SOC corresponding to the charging C-RATE, the charging C-RATE may be changed.

The charging protocol generating apparatus 100 according to the present disclosure may generate a charging protocol that prevents lithium plating from occurring during a charging process. Therefore, according to the charging protocol generated by the charging protocol generating apparatus 100, unintentional degradation of the battery due to charging may be prevented. That is, the charging protocol generating apparatus 100 has an advantage in that it may generate a charging protocol that may increase the expected lifespan of the battery by preventing unnecessary degradation of the battery.

Meanwhile, the profile obtaining unit 110 and the control unit 120 included in the charging protocol generating apparatus 100 may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the profile obtaining unit 110 and the control unit 120 may be implemented as a set of program modules. At this time, the program module may be stored in the memory and executed by the profile obtaining unit 110 and the control unit 120. The memory may be inside or outside the profile obtaining unit 110 and the control unit 120 and may be connected to the control unit 120 by various well-known means.

In addition, the charging protocol generating apparatus 100 may further include a storage unit 130. The storage unit 130 may store data necessary for operation and function of each component of the charging protocol generating apparatus 100, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the profile obtaining unit 110 and the control unit 120 are defined.

For example, the storage unit 130 may store a charging profile, a resistance profile, and a charging protocol.

In another embodiment, the control unit 120 may be configured to calculate the voltage drop by calculating the difference between the voltage of the target point and the voltage of the end point in each of a plurality of rest periods.

Specifically, the resistance calculated according to the voltage drop between the start point and the end point of the rest period is a value that includes both the ohmic resistance (Ro) and the charge transfer resistance (Rct) of the battery. However, since the ohmic resistance of the battery is not an indicator of lithium plating, it is desirable to consider only the charge transfer resistance in order to set the maximum allowable SOC related to lithium plating.

For example, when the ohmic resistance is excessively large, it is difficult to set the maximum allowable SOC that may prevent lithium plating because the ratio of charge transfer resistance to the resistance of the rest period is low. That is, the ohmic resistance of the battery may act as noise in terms of lithium plating. Therefore, when generating a charging protocol to prevent lithium plating, it is desirable to exclude the ohmic resistance and consider only the charge transfer resistance.

Specifically, in order to calculate the charge transfer resistance, the control unit 120 may calculate the voltage drop by calculating the difference between the voltage of the target point and the voltage of the end point and may calculate the resistance corresponding to the rest period based on the calculated voltage drop and the charging current. For example, in the embodiment of FIG. 3, the control unit 120 may calculate the voltage drop (Vt - Vd) between the voltage (Vt) of the target point Pt and the voltage (Vd) of the end point Pd, and may calculate the resistance of the rest period by calculating the formula of "(Vt - Vd) ÷ Ic".

That is, the resistance corresponding to the start point of the rest period (resistance calculated according to the formula "(Vs - Vd) ÷ Ic") is a value that includes both the ohmic resistance and the charge transfer resistance of the battery, and the resistance corresponding to the target point of the rest period (resistance calculated according to the formula "(Vt - Vd) ÷ Ic") is a value that includes only the charge transfer resistance of the battery.

The charging protocol generating apparatus 100 has the advantage of being able to generate a charging protocol that further prevents lithium plating from occurring during the charging process by excluding ohmic resistance and considering only charge transfer resistance.

Here, the control unit 120 may be configured to determine the target point as a point with the largest voltage among points where an instantaneous rate of change of voltage is greater than or equal to a preset reference change rate in each of a plurality of rest periods.

Specifically, when entering the rest period (i.e., when the battery stops charging), the ohmic resistance and charge transfer resistance sequentially affect the voltage of the battery, causing the voltage to drop. First, immediately after charging stops and entering the rest period, the voltage of the battery immediately drops due to the effect of the ohmic resistance. After that, the voltage of the battery gradually drops due to the effect of the charge transfer resistance.

For example, in the embodiment of FIG. 3, when entering the rest period, the voltage of the battery immediately drops from Vs to Vt due to the influence of ohmic resistance. Thereafter, the voltage of the battery gradually drops from Vt to Vd due to the influence of charge transfer resistance. That is, the voltage drop due to ohmic resistance progresses rapidly, but the voltage drop due to charge transfer resistance progresses more gradually.

Therefore, the control unit 120 may determine the target point based on the result of comparing the instantaneous rate of change of the voltage and the reference change rate in order to determine the point affected by the charge transfer resistance as the target point. This is because the instantaneous rate of change of the voltage dropped due to the influence of the ohmic resistance is less than the reference change rate, but the instantaneous rate of change of the voltage dropped due to the influence of the resistance transfer resistance is greater than the reference change rate.

More specifically, the control unit 120 may be configured to set the voltage change rate of the start point and the end point in each of a plurality of rest periods as a reference change rate corresponding to the rest period.

Specifically, the voltage change rate for the start point and the end point of the rest period is greater than the voltage change rate by the ohmic resistance and equal to or less than the voltage change rate by the charge transfer resistance. Therefore, the control unit 120 may set the voltage change rate of the start point and the end point of the rest period as the reference change rate in order to more accurately determine the target point at which the charge transfer resistance begins to have an effect in each rest period. That is, the control unit 120 may set the average change rate of the voltage of the rest period as the reference change rate for the corresponding rest period.

For example, in the embodiment of FIG. 3, the voltage change rate of the start point and the end point of the rest period may be determined according to the formula of "(Pd - Ps) ÷ ΔT". The control unit 120 may set the voltage change rate of the start point Ps and the end point Pd of the rest period as the reference change rate, and determine points whose instantaneous voltage change rate in the rest period is greater than or equal to the reference change rate. Then, the control unit 120 may determine the point with the largest corresponding voltage among the determined points as the target point Pt.

That is, according to the charging protocol generating apparatus 100, the target point where the influence of the charge transfer resistance begins may be set more accurately among a plurality of points where the voltage change rate is higher than or equal to the reference change rate. In addition, since the reference change rate may be set for each rest period, a charging protocol reflecting the current state of the battery may be generated by setting the reference change rate for each rest period that reflects the current state of the battery.

The charging protocol generating apparatus 100 according to the present disclosure may be applied to a battery management system (BMS). That is, the BMS according to the present disclosure may include the charging protocol generating apparatus 100 described above. In this configuration, at least some of components of the charging protocol generating apparatus 100 may be implemented by supplementing or adding functions of the components included in a conventional BMS. For example, the profile obtaining unit 110, the control unit 120 and the storage unit 130 of the charging protocol generating apparatus 100 may be implemented as components of the BMS.

Additionally, the charging protocol generating apparatus 100 according to the present disclosure may be provided in a battery pack. That is, the battery pack according to the present disclosure may include the above-described charging protocol generating apparatus 100 and at least one battery cell. Additionally, the battery pack may further include electrical components (relays, fuses, etc.) and a case.

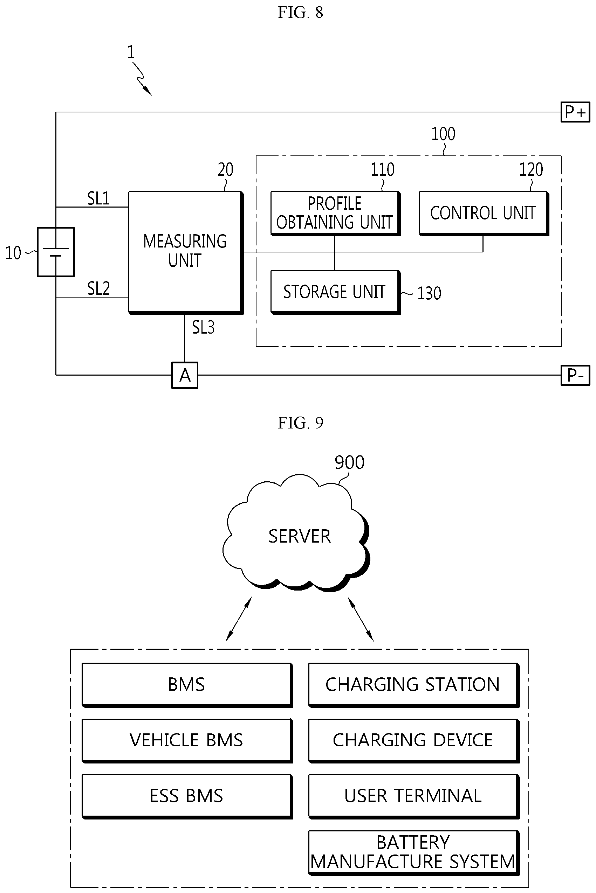

FIG. 8 is a diagram schematically showing a battery pack 1 according to still another embodiment of the present disclosure.

The positive electrode terminal of the battery 10 may be connected to the positive electrode terminal P+ of the battery pack 1, and the negative electrode terminal of the battery 10 may be connected to the negative electrode terminal P- of the battery pack 1.

The measuring unit 20 may be connected to the first sensing line SL1, the second sensing line SL2, and the third sensing line SL3. Specifically, the measuring unit 20 may be connected to the positive electrode terminal of the battery 10 through the first sensing line SL1 and connected to the negative electrode terminal of the battery 10 through the second sensing line SL2. The measuring unit 20 may measure the voltage of the battery 10 based on the voltage measured at each of the first sensing line SL1 and the second sensing line SL2.

Also, the measuring unit 20 may be connected to the current measuring unit A through the third sensing line SL3. For example, the current measuring unit A may be an ammeter or a shunt resistor capable of measuring the charging current and the discharging current of the battery 10. The measuring unit 20 may measure the charging current of the battery 10 through the third sensing line SL3 to calculate the charging amount. Also, the measuring unit 20 may measure the discharging current of the battery 10 through the third sensing line SL3 to calculate the discharging amount.

For example, the profile obtaining unit 110 may directly receive the charging profile of the battery from the measuring unit 20. That is, the profile obtaining unit 110 may obtain the charging profile by being connected to the measuring unit 20 by wire and/or wirelessly and receiving the charging profile.

As another example, the profile obtaining unit 110 may receive voltage information according to the charging time of the battery from the measuring unit 20. Then, the profile obtaining unit 110 may generate a charging profile based on the received voltage information. That is, the profile obtaining unit 110 may obtain a charging profile by directly generating the charging profile based on the voltage information of the battery.

An external device may be connected to the positive terminal P+ and the negative terminal P- of the battery pack 1. For example, the external device may be a charging device or a load. In addition, the positive terminal of the battery 10, the positive terminal P+ of the battery pack 1, the external device, the negative terminal P- of the battery pack 1, and the negative terminal of the battery 10 may be electrically connected.

FIG. 9 is a diagram schematically showing a server 900 according to still another embodiment of the present disclosure.

The server 900 according to still another embodiment of the present disclosure may include the charging protocol generating apparatus 100.

The server 900 may be connected to at least one BMS to enable wired and/or wireless communication. For example, the server 900 may be connected to enable communication with a BMS, a vehicle BMS equipped in a vehicle, and an ESS BMS equipped in an ESS. In addition, the server 900 may be connected to enable communication with a device capable of controlling charging of a battery, such as a charging station and a charging device, as well as a BMS. In addition, the server 900 may be connected to enable communication with at least one user terminal. In addition, the server 900 may be connected to enable communication with a battery manufacture system that manufactures a battery and sets initial data for the battery.

For example, the server 900 may receive a charging profile for a battery from the outside. Then, the server 900 may generate a charging protocol for the corresponding battery based on the charging profile. As another example, the server 900 may receive a charging profile for a reference battery and generate a reference charging protocol for a battery of the same type as the reference battery. Then, the server 900 may transmit the generated charging protocol to at least one device connected to enable communication.

In addition, the server 900 may check the state of the corresponding battery by storing the charging protocol for the battery and managing the history of changes in the charging protocol. For example, since the battery deteriorates as it is used, if a charging protocol generated for a BOL battery is applied to a MOL (Middle of life) battery, lithium plating may occur during the charging process. Therefore, the server 900 may update the charging protocol according to the state of the battery and check the state of the battery from the update history. For example, the server 900 may generate and update the charging protocol for the battery whenever the SOH of the battery decreases by a preset threshold value. In one embodiment, the server 900 may update the charging protocol for the battery whenever the SOH of the battery decreases by 2%.

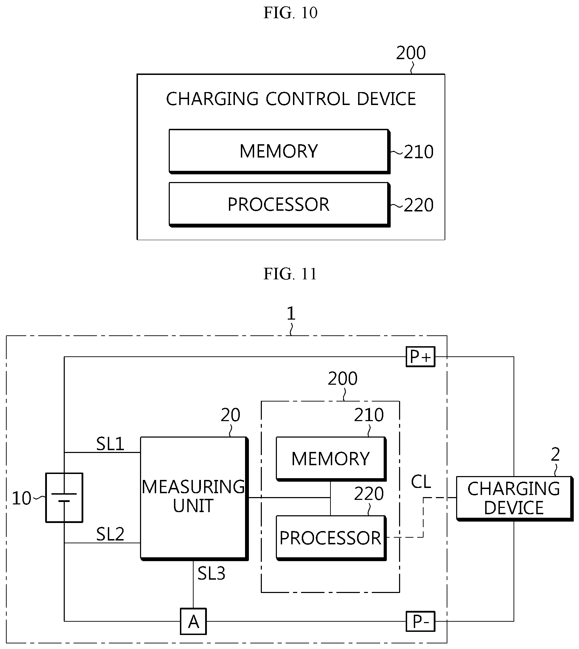

FIG. 10 is a diagram schematically showing a charging control device 200 according to still another embodiment of the present disclosure.

Referring to FIG. 10, the charging control device 200 may include a memory 210 and a processor 220.

Specifically, the charging protocol set by the charging protocol generating apparatus 100 may be stored in the memory 210. Then, when the processor 220 needs to control charging of the target battery, the processor 220 may access the memory 210 to obtain the stored charging protocol. Then, the processor 220 may be configured to control charging of the target battery based on the charging protocol.

Meanwhile, the processor 220 included in the charging control device 200 may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the processor 220 may be implemented as a set of program modules. At this time, the program module may be stored in the memory and executed by the processor 220. The memory may be inside or outside the processor 220 and may be connected to the processor 220 by various well-known means.

In addition, the memory 210 included in the charging control device 200 may store data necessary for operation and function of each component of the charging control device 200, data generated in the process of performing the operation or function, or the like. The memory 210 is not particularly limited in its kind as long as it is a known information storage means that can record, erase, update and read data. As an example, the information storage means may include RAM, flash memory, ROM, EEPROM, registers, and the like. In addition, the memory 210 may store program codes in which processes executable by the processor 220 are defined.

Additionally, the charging control device 200 according to the present disclosure may be provided in the battery pack 1. That is, the battery pack 1 according to the present disclosure may include the above-described charging control device 200 and at least one battery cell. Additionally, the battery pack 1 may further include electrical components (relays, fuses, etc.) and a case.

FIG. 11 is a diagram schematically showing a battery pack 1 according to still another embodiment of the present disclosure. The battery 10, the measuring unit 20, and the first to third sensing lines SL1, SL2, SL3 included in the battery pack 1 are the same as those illustrated in FIG. 8, so a detailed description thereof is omitted.

The battery information measured by the measuring unit 20 may be transmitted to the charging control device 200. For example, the measuring unit 20 and the charging control device 200 may be connected to enable wired or wireless communication. The battery information received from the measuring unit 20 may be stored in the memory 210 and input to the processor 220. Additionally, the processor 220 may access the memory 210 to obtain the stored battery information.

The charging device 2 may be connected to the positive terminal P+ and the negative terminal P- of the battery pack 1. Here, the charging device 2 is a device for charging the battery 10.

The processor 220 may be connected to the charging device 2 via a communication line CL to enable wired and/or wireless communication. For example, the processor 220 may perform power-line communication (PLC) with the charging device 2. The processor 220 may determine whether the SOC of the battery 10 has reached the charging upper limit SOC corresponding to the current C-rate based on the charging protocol stored in the memory 210. If the SOC of the battery 10 has reached the charging upper limit SOC, the processor 220 may command the charging device 2 to decrease the C- RATE. Preferably, the processor 220 may select a C- RATE lower than the current C- RATE in the charging protocol, and command the charging device 2 to charge at the selected C- RATE.

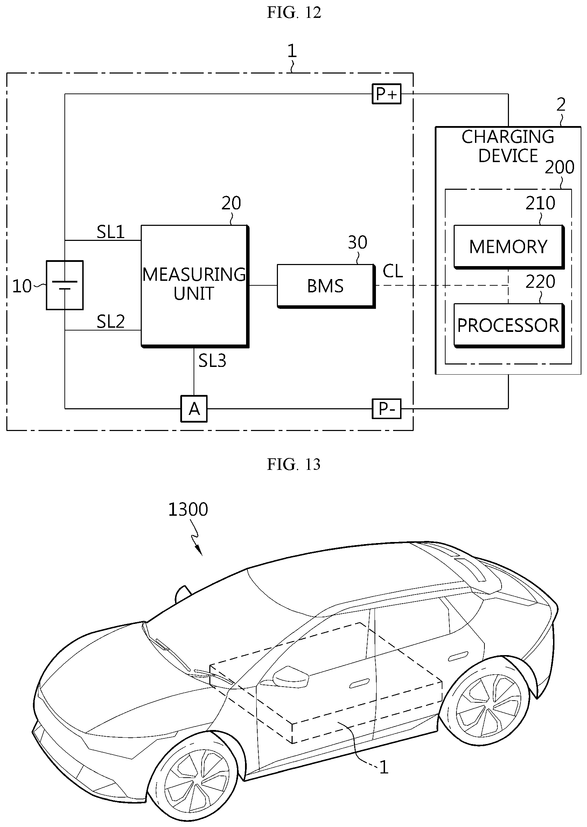

FIG. 12 is a diagram schematically showing a charging device according to still another embodiment of the present disclosure.

The battery pack 1 may include the battery 10, the measuring unit 20, and the BMS 30. Here, the BMS 30 is a battery management system that diagnoses the state of the battery and controls charging and discharging of the battery. For example, the BMS 30 may be a configuration that has been widely used in the past.

The charging device 2 may include the charging control device 200. For example, the charging device 2 may output the charging current at a C-RATE set by the charging control device 200.

The BMS 30 may be connected to the charging device 2 via the communication line CL to enable wired and/or wireless communication. Preferably, the charging device 2 may receive the battery information from the BMS 30. Then, the battery information may be stored in the memory 210 and input to the processor 220. In addition, the processor 220 may access the memory 210 to obtain the stored battery information.

The processor 220 may determine whether the SOC of the battery 10 has reached the charging upper limit SOC corresponding to the current C-RATE based on the charging protocol stored in the memory 210. If the SOC of battery 10 has reached the charging upper limit SOC, the processor 220 may reduce the charging C-RATE. That is, the processor 220 may reduce the charging current output from the charging device 2. Preferably, the processor 220 may select a C-RATE lower than the current C-RATE in the charging protocol, and change the C-RATE of the charging current output from the charging device 2 to the selected C-RATE. Therefore, the charging device 2 may output the charging current corresponding to the lowered C-RATE toward the battery 10.

FIG. 13 is a diagram schematically showing a vehicle 1300 according to still another embodiment of the present disclosure.

Referring to FIG. 13, the battery pack 1 according to an embodiment of the present disclosure may be included in a vehicle 1300 such as an electric vehicle (EV) or a hybrid vehicle (HV). Additionally, the battery pack 1 may drive the vehicle 1300 by supplying power to the motor through an inverter provided in the vehicle 1300. For example, the battery pack 1 may include the charging control device. That is, the vehicle 1300 may include the charging protocol generating apparatus 100 and/or the charging control device 200.

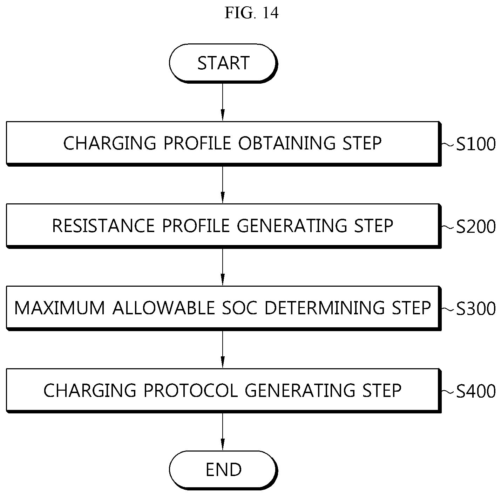

FIG. 14 is a diagram schematically showing a charging protocol generating method according to still another embodiment of the present disclosure.

Referring to FIG. 14, the charging protocol generating method may include a charging profile obtaining step (S100), a resistance profile generating step (S200), a maximum allowable SOC determining step (S300), and a charging protocol generating step (S400).

Preferably, each step of the charging protocol generating method may be performed by the charging protocol generating apparatus 100. Hereinafter, for convenience of explanation, content that overlaps with the content described above will be omitted or briefly described.

The charging profile obtaining step (S100) is a step of obtaining a charging profile of a battery charged by repeating a charging period and a rest period at a preset charging C-RATE, and may be performed by the profile obtaining unit 110.

For example, the profile obtaining unit 110 may directly receive the charging profile of the battery from the outside. That is, the profile obtaining unit 110 may obtain the charging profile by being connected to the outside via wire and/or wirelessly and receiving the charging profile.

As another example, the profile obtaining unit 110 may receive voltage information according to the charging time of the battery from the outside. Then, the profile obtaining unit 110 may generate a charging profile based on the received voltage information. That is, the profile obtaining unit 110 may obtain a charging profile by directly generating the charging profile based on the voltage information of the battery.

The resistance profile generating step (S200) is a step of generating a resistance profile representing a corresponding relationship between resistance and SOC of a plurality of rest periods, and may be performed by the control unit 120.

First, the control unit 120 may be configured to calculate the resistance of each of the plurality of rest periods based on the voltage drop of each of the plurality of rest periods and the current value corresponding to the charging C-RATE. Then, the control unit 120 may estimate the SOC corresponding to each of the plurality of rest periods. Finally, the control unit 120 may generate a resistance profile by mapping the corresponding resistance and SOC.

The maximum allowable SOC determining step (S300) is a step of determining a maximum allowable SOC corresponding to the charging C-RATE based on the resistance pattern of the target SOC section of the generated resistance profile, and may be performed by the control unit 120.

For example, the control unit 120 may be configured to set the maximum allowable SOC to the upper limit SOC when the resistance corresponding to the upper limit SOC of the target SOC section is largest among the plurality of resistances corresponding to the target SOC section of the resistance profile.

As another example, the control unit 120 may be configured to set the maximum allowable SOC based on at least one maximum point when a resistance greater than the resistance corresponding to the upper limit SOC of the target SOC section exists among the plurality of resistances corresponding to the target SOC section of the resistance profile and at least one maximum point exists in the target SOC section.

As another example, the control unit 120 may be configured to set the maximum allowable SOC based on the at least one inflection point, if a resistance greater than the resistance corresponding to the upper limit SOC of the target SOC section exists among the plurality of resistances corresponding to the target SOC section of the resistance profile, no maximum point exists in the target SOC section, and at least one inflection point exists in the target SOC section.

The charging protocol generating step (S400) is a step of generating a charging protocol including a corresponding relationship between the charging C-RATE and the maximum allowable SOC, and may be performed by the control unit 120.

The control unit 120 may set a maximum allowable SOC corresponding to the charging C-RATE and generate a charging protocol representing a corresponding relationship between them. That is, the charging protocol may include information on the maximum allowable SOC at which lithium plating does not occur for each charging C-RATE.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

1: battery pack
2: charging device
10: battery
20: measuring unit
30: BMS
100: charging protocol generating apparatus
110: profile obtaining unit
120: control unit
130: storage unit
200: charging control device
210: memory
220: processor
900: server
1300: vehicle

## Claims

1. A charging protocol generating apparatus, comprising:
a profile obtaining unit configured to obtain a charging profile of a battery charged by repeating a charging period and a rest period at a preset charging C-RATE; and
a control unit configured to generate a resistance profile representing a corresponding relationship between a resistance of the plurality of rest periods and SOC (State of Charge), determine a maximum allowable SOC corresponding to the charging C-RATE based on a resistance pattern of a target SOC section of the generated resistance profile, and generate a charging protocol including a corresponding relationship between the charging C-RATE and the maximum allowable SOC.

2. The charging protocol generating apparatus according to claim 1,
wherein the control unit is configured to calculate the resistance of each of the plurality of rest periods based on a voltage drop of each of the plurality of rest periods and a current value corresponding to the charging C-RATE.

3. The charging protocol generating apparatus according to claim 2,
wherein the control unit is configured to calculate the voltage drop by calculating a difference between a voltage at a target point and a voltage at an end point in each of the plurality of rest periods.

4. The charging protocol generating apparatus according to claim 3,
wherein the control unit is configured to determine the target point as a point with a largest voltage among points where an instantaneous rate of change of voltage is greater than or equal to a preset reference change rate in each of the plurality of rest periods.

5. The charging protocol generating apparatus according to claim 4,
wherein the control unit is configured to set a voltage change rate of a start point and the end point as the reference change rate corresponding to the rest period in each of the plurality of rest periods.

6. The charging protocol generating apparatus according to claim 1,
wherein when a resistance corresponding to an upper limit SOC of the target SOC section is largest among the plurality of resistances corresponding to the target SOC section of the resistance profile, the control unit is configured to set the maximum allowable SOC as the upper limit SOC.

7. The charging protocol generating apparatus according to claim 1,
wherein when a resistance greater than a resistance corresponding to an upper limit SOC of the target SOC section exists among the plurality of resistances corresponding to the target SOC section of the resistance profile and at least one maximum point exists in the target SOC section, the control unit is configured to set the maximum allowable SOC based on the at least one maximum point.

8. The charging protocol generating apparatus according to claim 1,
wherein when a resistance greater than a resistance corresponding to an upper limit SOC of the target SOC section exists among the plurality of resistances corresponding to the target SOC section of the resistance profile, no maximum point exists in the target SOC section, and at least one inflection point exists in the target SOC section, the control unit is configured to set the maximum allowable SOC based on the at least one inflection point.

9. A battery pack, comprising the charging protocol generating device according to any one of claims 1 to 8.

10. A server, comprising the charging protocol generating device according to any one of claims 1 to 8.

11. A battery charging control device, comprising:
a memory configured to store the charging protocol generated by the charging protocol generating apparatus according to any one of claims 1 to 8; and
a processor configured to control charging of a charging target battery based on the charging protocol.

12. A charging protocol generating method, comprising:
a charging profile obtaining step of obtaining a charging profile of a battery charged by repeating a charging period and a rest period at a preset charging C-RATE;
a resistance profile generating step of generating a resistance profile representing a corresponding relationship between a resistance of the plurality of rest periods and SOC (State of Charge);
a maximum allowable SOC determining step of determining a maximum allowable SOC corresponding to the charging C-RATE based on a resistance pattern of a target SOC section of the generated resistance profile; and
a charging protocol generating step of generating a charging protocol including a corresponding relationship between the charging C-RATE and the maximum allowable SOC.
